(19) Europäisches Patentamt
European Patent Office
Office européen des brevets

(11) Publication number: **0 064 926**
**B1**

# (12) EUROPEAN PATENT SPECIFICATION

(45) Date of publication of patent specification: **02.10.85**

(51) Int. Cl.$^4$: **G 03 F 7/10,** H 01 L 21/02

(21) Application number: **82400835.3**

(22) Date of filing: **06.05.82**

## (54) A lithographic process resulting in positive images.

(30) Priority: **08.05.81 US 261691**

(43) Date of publication of application:
**17.11.82 Bulletin 82/46**

(45) Publication of the grant of the patent:
**02.10.85 Bulletin 85/40**

(84) Designated Contracting States:
**DE FR NL**

(56) References cited:
**none**

(73) Proprietor: **Western Electric Company, Incorporated**
**222 Broadway**
**New York, NY 10038 (US)**

(72) Inventor: **Fahrenholtz, Susan Roseno**
**28 Winding Lane**
**Bloomfield New-Jersey 07003 (US)**

(74) Representative: **Flechner, Willy et al**
**CABINET FLECHNER 22, Avenue de Friedland**
**F-75008 Paris (FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 064 926 B1

**Description**

Background of the Invention

1. Field of the Invention

This invention relates to electron lithography utilized in the production of semiconductor devices.

2. Art Background

Electron lithographic processes are widely used in the production of semiconductor devices. Generally, a substrate such as a silicon wafer that is being processed to form a plurality of devices or a chrome layer being prepared as a lithographic mask is coated with a layer of an electron sensitive composition. The electron sensitive composition, i.e., the resist material, is then exposed with electrons in a desired pattern. The electrons induce a chemical change in the exposed area. Thus, after patterning, the exposed region differs chemically from the regions not impacted by the electrons. A solvent is then employed to develop the image either by dissolving the exposed regions while essentially leaving the unexposed regions unaffected or, conversely, by dissolving the unexposed regions and leaving the exposed regions unaffected. In the former situation where the exposed region is more soluble, the resist is considered positive and in the latter the resist is considered negative. Thus, the more soluble regions, i.e., the unexposed regions in negative resists and the exposed regions in positive resists, are removed by using a suitable solvent. In this manner, the latent image produced by exposure is developed. The developed image is then utilized as a mask for various processes such as metallization and etching.

Many expedients have been used to enhance the solubility of the exposed region in the case of positive resists, to enhance the insolubility of the exposed region in the case of negative resists, or to change resists from positive to negative acting. For example, the grafting of monomers onto the soluble chemically modified polymer in the exposed regions of a positive resist has been employed to produce a composition in those regions which is insoluble. Thus, the image is converted from positive to negative. Specifically, poly(methyl methacrylate) is subjected to actinic radiation to produce free radicals and then exposed to acrylic acid which reacts with these radicals. The acrylic acid reacts with the modified polymer in the exposed region and significantly reduces its solubility. (See M. Gazard et al. *Society of Plastics Engineers, Inc.,* Regional Technical Conference, Mid-Hudson section, October 10, 1979, Ellenville, New York, page 106.)

Although various expedients are employed to reproducibly control the solubility of the exposed regions of a resist, e.g., to increase the solubility of the exposed regions in positive resists and to decrease the solubility of the exposed regions in negative resists, a variety of factors often cause just the opposite result. For example, the use of high doses of electrons have been reported to decrease the solubility of the exposed regions of positive resists containing novolac resins, i.e., phenol-formaldehyde polymers. In these resists soluble novolac resins are used in combination with an inhibitor material that is insoluble in a given developer and renders the resin insoluble. Upon exposure, generally, the solubility of the novolac is unchanged, but the solubility of the exposed inhibitor is substantially increased. Although unexposed regions are insoluble due to the unaffected inhibitor, exposed regions are soluble. (The resist is positive). However, at higher doses the exposing electrons significantly decrease the solubility of the exposed novolac and, in turn, the solubility of the exposed regions. This decrase in solubility due to high exposure and the resulting decrease in the positive properties of the resist are postulated to be caused by crosslinking in the resin. (See M. Kaplan and D. Meyerhofer, *Society of Plastics Engineers, Inc.,* Regional Technical Conference, Mid-Hudson Section, October 10, 1979, Ellenville, New York, page 118). Thus, although a wide range of expedients improve the properties of resist materials, an equally wide range of factors occur which have exactly the opposite effect.

Summary of the Invention

The process of the invention is defined in claim 1. Other preferable features of the invention are mentioned in claims 2—9.

It has been found that for typical developers the relative solubility of the exposed regions of novolac resins, i.e., resins formed by the reaction of formaldehyde with a phenol or with a substituted phenol, is significantly increased by controlling the exposure dose, the post exposure treatment of the resist, and the composition (the monomer components and molecular weight) of the resist. These factors should be controlled so that formation of base soluble products formed by reaction of free radicals with oxygen rather is favored over cross-linking in the exposed regions of novolac resins. In addition to appropriate composition and exposure dosage, post exposure conditions for producing this result include exposing the resist to oxygen before the post exposure baking of the resist if any, and employing a relatively strongly basic developer.

Brief Description of the Drawing

FIGS. 1 and 2 illustrate conditions affecting the inventive process.

Detailed Description

The appropriate processing of resists that include novolac resins yields a positive image. When the

novolac resin is used without an inhibitor, a previously unobserved ability to use the material as a positive resist is observed. the novolac is also employable with an additive, such as benzoyl peroxide, that is insoluble before exposure, but more soluble after exposure to produce advantageous positive resist images. The dosage of the exposing radiation, the composition of the novolac resin, and the post exposure processing steps affect the image that is obtained. Indeed, these parameters, i.e., the dosage, composition, and post exposure processing step, having an interrelated effect on whether a negative or positive image results. For example, in relation to composition, the larger the substituent R in the novolac resin represented by

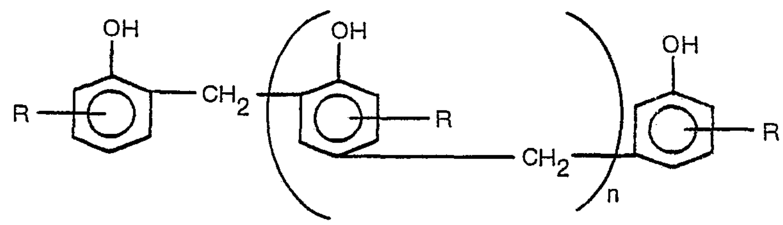

the more positive the image obtained. (A more positive image is signified by an increased rate of solubility for a given developer of the exposed regions as compared to the unexposed portions of the resist material, and thus typified by a deeper relief image). Further, for a given polymer, the depth of the relief image is greater, the higher the initial molecular weight.

Exemplary of the influence of post exposure processing is the effect of post exposure heating. The sooner the resist is heated after exposure, the less positive the image. Indeed, baking the sample immediately after exposure yields a negative image. Additionally, the stronger the base used as a developer, the more positive the image, and the greater the concentration of oxygen in the ambient atmosphere after exposure, the more positive the image.

In terms of the effects of exposure conditions, for higher dosages — dosages above $4.8 \times 10^{-6}$ C/cm$^2$ —, the use of larger substituents for R, e.g., *n*-propyl, *t*-butyl, and phenyl, yields a more positive image, and the use of smaller R substitutuents, e.g., methyl, yields a less positive image for the same degree of polymerization. (As previously discussed, within the same polymer the larger molecular weight the more positive the image).

Although a precise, detailed mechanistic explanation of these empirical observations is not entirely elucidated, free radicals are formed upon exposure and if these free radicals are induced to react with oxygen to form a hydroperoxide or other base soluble oxygen containing substituent, a more positive image is obtainable. However, if these free radicals react with each other to produce crosslinking, a less positive or, for extensive crosslinking, a negtive image is formed. Thus, the invention resides in the utilization of processing conditions and novolac resist compositions that favour free radical interaction with oxygen to form base soluble substituents and that disfavor the branching or crosslinking of the novolac. With this requisite in mind, the following discussion will relate each of the previously discussed observations to this criterion.

Although, as discussed, a precise detailed mechanistic description is not appropriate, as a pedagogic aid, two general reaction paths, one leading to crosslinking and one leading to oxygen substituent formation, are useful and are represented by the reaction paths

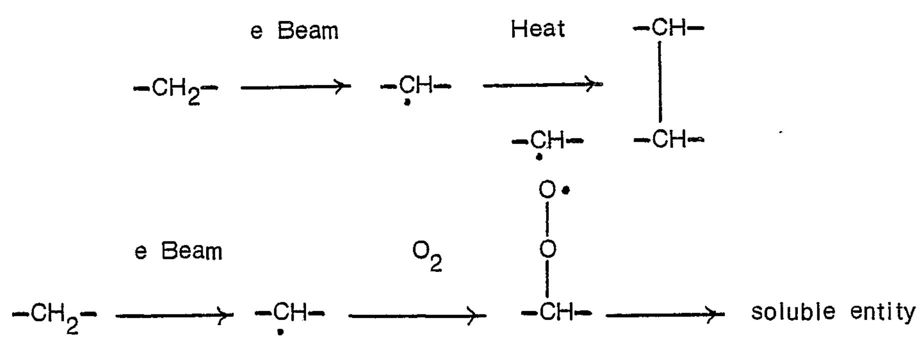


(1)

(2)

When R is a substituent such as an *n*-propyl, *t*-butyl, or a pheny moiety, and the melting point of the polymer is above 100 degrees C, a positive image is obtained essentially irrespective of the other typical conditions employed. (This statement assumes the use of nominal not extreme conditions). The use of such groups hinders free radical interaction and appears to substantially inhibit crosslinking.

The results obtained, for the same degree of polymerization, when a smaller substituent is employed, e.g., R = methyl, depend on other processing conditions. (The discussion of the effect of molecular weights is discussed later). Specifically, the dosage employed significantly affects the image obtained when R is a smaller substituent. As shown in FIG. 1 when R is a methyl group (as denoted by line 1) a progressively less positive image is obtained as the dosage approaches $1.8 \times 10^{-5}$ C/cm$^2$. For dosages above this limit, a

progressively more negative image results. A contemplated explanation for this phenomenon is that higher doses produce more free radicals. Since a larger number of free radicals is produced, and since effects that hinder crosslinking are not present, the probability of two radicals being close enough to react with each other is increased. Thus, crosslinking is increased. However, at lower doses, it is less likely that two free radicals will be in close proximity and it is less likely that crosslinking will occur. In the latter case when a smaller dosage is utilized there is less chance for crosslinking during and after irradiation and, thus, a greater chance for subsequently producing appropriate oxygen containing substituents when exposed to a suitable atmosphere of oxygen.

The dosage also has an effect on image quality when a larger R is employed. In this case a positive image is obtained even at relatively high doses. Further, the greater the dosage the more positive the image. A contemplated explanation for this phenomena is that higher dosages result in a greater concentration of free radicals. However, because of the large R group, these free radicals even if in relatively close proximity to each other are prevented, as discussed earlier, from interacting to cause crosslinking. These free radicals are then capable of forming hydroperoxides or other base soluble oxygen containing substituents. Thus, the higher the dosage, the greater the eventual oxygen substituent concentration and the more positive the image. However, excessively high doses, doses generally over $10^{-4}C/cm^3$, cause excessive crosslinking irrespective of composition and generally should be avoided. Within this limitation a control sample should be employed to determine the preferred dosage for a given resist composition.

Baking the exposed electron sensitive material soon after exposure is not desirable. For example, in a novolac resin when R is an *n*-propyl group a positive image is obtained if heating after exposure is not performed or if it is delayed for 24 hours. (These time periods are those observed when air constitutes the environment for the resist). Additionally, an environment having a greater oxygen concentration reduces the delay between exposure and baking that yields a desired positive image. If the resist is not baked, typically sufficient reaction with oxygen has occurred 20 minutes after exposure so that after this elapsed time development to yield a positive image is possible. (Again, this behavior emphasizes the interdependent effect of the processing conditions and the polymer composition on the image quality). If immediately after exposure, the electron sensitive material is baked, for example, at 100 degrees C, a negative image is obtained. This observation is also explainable in terms of the crosslinking versus the oxygen substituent formation mechanism. Heating favors the crosslinking rather than the oxygen substituent formation pathway because it increases the translational motion of the polymer chains and induces the free radicals formed during exposure to approach each other sufficiently close to react, even in compositions with larger R's. Therefore, the heating of the resist material induces the free radicals present to crosslink and reduces substantially the formation of oxygen substituents. Heating directly after exposure severely limits oxygen substituent formation and as a result prevents the development of a positive pattern. A delayed heating procedure allows time for oxygen substituent formation and promotes positive image formation.

Generally, the use of shorter development times, e.g., times less than 1 minute, with stronger developers yield a more positive image. For example, a 2-*t*-butylphenol substituted novolac resist material developed for 65 seconds in AZ—303A/$H^2O$ developer (a proprietary product of Shipley Corp. which is basically a NaOH solution) in a 2:3 ratio yields a negative image. The same material developed for 15 seconds in AZ—303A/$H^2O$ in a 2:1 ratio yields a positive image, and when developed for 4—1/2 seconds in undiluted AZ—303A developer yields an even more positive image. The contemplated explanation of this phenomenon is that it takes a stronger base to effect dissolution of a material through interaction with an oxygen substituent such as a hydroperoxide than through interaction with a phenol. Once this interaction occurs, the peroxide containing material dissolves more readily than the same material without the peroxide moiety.

Despite the generally advantageous effect of a stronger developer, the developer should not be so strong as to dissolve the unexposed regions of the resist material at a significant rate. Typically, upon removal of substantially the entire thickness of the exposed region by development, the percentage of the original thickness of the unexposed region preferably should not be reduced more than 80%, most preferably not more than 70%. Within this restriction, generally the stronger the developer, the more positive the obtainable image.

The greater the oxygen content of the environment, and the longer the treatment of the exposed resist to this environment, the more positive the image. As shown in the following table for the same resist and the same post exposure processing, different results are obtained depending upon the concentration of oxygen in the environment.

TABLE I

| Conditions | Development Time to Substrate | Elapsed Time Since Exposure | Depth of Pattern in nm | (Å) |
|---|---|---|---|---|
| nitrogen | 68 s | 16 h | 72 | (720) |
| air | 55 s | 16 h | 189 | (1890) |
| oxygen | 50 s | 16 h | 207 | (2070) |
| air | 50 s | 7 days | 320 | (3200) |

As shown by the table an oxygen ambient produces a more positive image than an air ambient which, in turn, produces a more positive image than an inert gas environment. A consistent explanation for this phenomenon is that the greater the concentration of oxygen present, the faster the rate of reaction to form oxygen containing substituents. Typically, for most novolac resins an exposure to air for time periods of 20 minutes or greater produces an adequate positive image. The longer the exposure to air, up to one week, the more positive the image. Similarly, the exposure to an oxygen atmosphere for time periods greater than 20 minutes produces suitable images.

The molecular weight of the novolac resin also affects the image obtained. Generally, the greater the molecular weight, the more positive the image. However, molecular weights should not be increased to the point where the exposed region even with treatment with oxygen is no longer base soluble. (This lack of solubility with very high molecular weight is generally observed with novolac resins and results from effects other than crosslinking). Molecular weights less than 500 generally lead to negative rather than positive images. The effect of molecular weight most probably results from the increase in glass transition temperature of the resist with increase of molecular weight. As the glass transition temperature increases, the ability of polymer chains to move is decreased. Because of the decreased mobility, free radicals are less likely to come within interaction distances of each other and less likely to crosslink.

The subject process, as discussed, involves (1) the exposure of a resist coated on a substrate e.g., a silicon wafer or chrome mask material, (2) the development of the latent image by using exposure conditions, resist compositions, and processing conditions that promote formation of base soluble oxygen containing substituents and reduce crosslinking, and (3) ultimately the processing, e.g., metallization or etching of the underlying substrate using the image as a mask.

The following examples illustrate these exposure, processing, and composition parameters:

## Example 1

Approximately 100.5 g of 2-*n*-propylphenol was mixed with approximately 66.5 g of a 37% formaldehyde in water solution. Approximately 6 g of oxalic acid was added to the mixture. The mixture was heated to reflux temperature and maintained with stirring at this temperature overnight. The heating was discontinued for 72 hours and 5 ml of 37% HCl was added. The mixture was heated to reflux temperature and maintained at this temperature for 20 hours. Approximately 300 ml of distilled water was added to the reaction mixture to remove the HCl and the unreacted formaldehyde. The aqueous phase was removed by decanting. The polymer was rinsed with another aliquot of approximately 300 ml of distilled water. The polymer was transferred to a flask and heated under vacuum until it melted. The volatile components were trapped in a dry ice receiver. Heating under vacuum was continued until no further evolution and trappiung of volatile components were observed. (Throughout this process, the temperature of the polymer was carefully regulated to remain below 300 degrees C). The resulting novolac resin had a molecular weight of approximately 1800 and a melting point of approximately 101 to 108 degrees C.

A variety of other novolac resins were synthesized by the same procedure using the particular phenol and the particular ratio of phenol to formaldehyde as indicated in the following table:

TABLE II

| Phenol Component | 37% Aqueous Formaldehyde Solution | Molecular Weight | Spinning Speed in r.p.m. | Developer | Developing Time | Thickness % |
|---|---|---|---|---|---|---|
| 2-*n*-propylphenol 100.5 g | 66.5 g | 1800 | 1800 | 35 g NaOH in 200 ml $H_2O$ | 28 s | 29 |
| 2-*n*-propylphenol 100.5 g | 59.9 g | 1200 | 1700 | AZ303A in $H_2O$ 3:2 | 60 s | 5 |
| *o*-cresol 70% *m*-cresol 15% | | 1200 | 1800 | AZ303A $H_2O$ in 1:6 ratio | 25 s | 4 |
| 2-*t*-butylphenol 15% (*o*-cresol novolac) | | 840 | 1800 | AZ in $H_2O$ in 4:3 ratio | 30 s | * |
| *o*-phenylphenol 80.3 g | 34 g | 1200 | 2000 | AZ developer** | 13 s | 9 |
| 2-*sec*-butylphenol 105.1 g | 51 g | | 1800 | AZ303A in $H_2O$ 1:1 | 20 s | 2 |

* Negative at this dosage.

** A proprietary developer of Shipley Corp. that is less basic than AZ–303A developer.

(The phenols in the list having an asterisk by them indicate that oxalic acid alone was used as the catalyst, and the novolacs made utilizing oxalic acid were heated overnight. The phenols without the asterisk were made using only HCl a a catalyst and were heated for 6 hours). The molecular weights are also shown in Table II.

Example 2

Approximately 18 g of polymer was dissolved in 72 ml of methoxyethylacetate. The resulting solution was filtered three times through a 0.25 μm filter. Enough of this solution was placed on a silicon wafer having a diameter of approximately 7.6 cm. (3 inches) so that the surface of the wafer was covered. The wafer was then spun at 1700 rpm for approximately 1 minute to yield a 1.1 μm thick layer. (The spinning speed varied somewhat for each novolac resin and the speed utilized for a particular resin is shown in Table II). The coated wafers were dried in an oven at 115 degrees C. A separate wafer was coated for each of the resins shown in Table II. (The coating thickness varied with the particular resin).

Example 3

Each wafer was exposed to electrons having an acceleration potential of approximately 20 kV. The dosage for each wafer was approximately $4.8 \times 10^{-6}$ C/cm$^2$. The pattern for the exposure was a test pattern including various sized lines and various sized spaces between these lines. After several hours, the latent image was developed by immersing the wafer in a suitable developer. The times for this development treatment and the particular development used for a specific resin is shown in Table II. Each of the wafers afforded excellent resolution, on the order of 1/2 μm. (This was the approximate diameter of the electron beam used for exposure). The percentage of the original thickness remaining after development of the unexposed portion of the resist, which is an indication of the relative solubilities of the exposed and unexposed regions, is also given in Table II.

Example 4

A 2-*n*-propylphenol resin was prepared as described in Example 1 and coated on a wafer as described in Example 2. The wafer with its resist was then exposed as described in Example 3 and placed in various environments as shown in Table I. After the environmental exposures shown in Table I, the wafers were developed as described in Example 3. The thicknesses of the unexposed regions after development are given in Table I.

Example 5

The *o*-cresol, *n*--propylphenol, (indicated by the *n*-propylphenol resin having the lower molecular weight in Table II) and *o*-phenylphenol resins were prepared as described in Example 1 and spun coated as described in Example 2. The separate resists were then exposed as described in Example 3, except the exposure dosage was varied across each wafer. After exposure, the wafers were kept in air for at least 24 hours. The wafers were then developed as described in Example 3.

Inspection of the wafers yielded the graph shown in FIG. 1. This graph demonstrates the effect of exposure on the relative thickness of the unexposed region of the developed image. The line denominated 1 corresponds to the *o*-cresol, the line denominated 3 corresponds to *n*-propylphenol, and the line denominated 5 corresponds to the *o*-phenylphenol.

Example 6

The resin corresponding to the 2-*sec*-butylphenol (shown in Table II) was prepared and spun coated onto a silicon wafer as described in Examples 1 and 2 respectively. The wafer was exposed using various dosages across the wafer surface. The wafer was then kept in air for at least 24 hours and then developed. The wafer was broken into several sections. These sections were developed in either 2.3 AZ—303A to water, 2:1 AZ—303A to water, and undiluted AZ—303A for 65, 15, or 4—1/2 seconds, respectively. The effect of the developer and exposure dosage is shown in FIG. 2 where lines 8, 10, and 12 correspond to the 2:3, 2:1, and undiluted solution, respectively.

Example 7

The 2-*n*-propylphenol novolac of higher molecular weight shown in Table II was prepared and coated on a wafer as described in Examples 1 and 2 respectively. The wafer with its resist was then exposed as described in Example 3. The exposed wafer was heated immediately after exposure to 110 degrees C for 1 hour and then developed as described in Example 3. A negative image was observed.

*Claims*

1. A lithographic process, especially useful in the production of semiconductor devices, comprising the steps of exposing an electron sensitive material coated on a substrate to an electron exposure to form a latent image wherein said electron sensitive material comprises a component consisting essentially of a novolac resin and developing the latent image thus formed by subjecting the exposed material to a basic solvent, characterized by employing a composition of said novolac resin, an exposure dose and treating the exposed resist with a gaseous fluid comprising oxygen after the exposure and prior to the developing so as

to promote a substantial reaction of said novolac resin with oxygen whereby upon development, when substantially the entire thickness of the exposed region of said resist is removed, at least 20% of the original thickness of the unexposed region of said resist remains.

2. The process according to claim 1, characterized in that conducting said treatment of the exposed resist for a period of at least 20 minutes.

3. The process according to claim 1, characterized by employing as the said novolac resin a resin comprising the reaction product of formaldehyde and phenylphenol or *n*-propylphenol or *t*-butylphenol.

4. The process according to claim 1, characterized by using said resin with a molecular weight of above 500.

5. The process according to claim 1, characterized by substantially avoiding baking of said resin after said exposure.

6. The process according to claim 1, characterized in that said substrate comprises a silicon substrate or a layer of chrome.

7. The process according to claim 1, characterized by using said developed image as a mask for processing said substrate.

8. The process according to claim 7, characterized by using said image during an etching process to form a chrome mask.

9. The process according to claim 7, characterized by using said image during an etching process or during a metallization process in the fabrication of a plurality of semiconductor devices.

**Patentansprüche**

1. Lithographisches Verfahren, insbesondere zur Verwendung bei der Herstellung von Halbleiterbauelementen, das die Schritte umfaßt Aussetzen eines elektronenempfindlichen Materials, mit dem ein Substrat beschichtet ist, einer Elektronenbestrahlung zum Erzeugen eines latenten Bildes, wobei das elektronenempfindliche Material eine im wesentlichen aus einem Novolac-Harz bestehende Komponente umfaßt, und Entwickeln des solcerart erzeugten latenten Bildes durch Aussetzen des bestrahlten Materials einem basischen Lösungsmittel, gekennzeichnet durch Verwendung einer Zusammensetzung des Novolac-Harzes, einer Bestrahlungsdosis und Anwendung einer Behandlung des bestrahlten Resists mit einem sauerstoffhaltigen gasförmigen Medium nach der Bestrahlung und vor der Entwicklung, um eine wesentliche Reaktion des Novolac-Harzes mit Sauerstoff zu fördern, wodurch nach Entwicklung, wenn praktisch die gesamte Dicke des bestrahlten Bereichs des Resists entfernt ist, wenigstens 20% der ursprünglichen Dicke des unbestrahlten Bereichs des Resists verbleiben.

2. Verfahren nach Anspruch 1, dadurch gekennzeichnet, daß die Behandlung des bestrahlten Resists für eine Zeitspanne von wenigstens 20 Minuten durchgeführt wird.

3. Verfahren nach Anspruch 1, gekennzeichnet durch Verwendung eines Harzes, das das Reaktionsprodukt von Formaldehyd und Phenylphenol oder n-Propylphenol oder *t*-Butylphenol umfaßt, als das Novolac-harz.

4. Verfahren nach Anspruch 1, gekennzeichnet durch Verwendung eines Harzes mit einem Molekulargewicht von mehr als 500.

5. Verfahren nach Anspruch 1, gekennzeichnet durch im wesentliches Vermeiden eines Backens des Harzes nach der Bestrahlung.

6. Verfahren nach Anspruch 1, dadurch gekennzeichnet, daß das Substrat ein Siliciumsubstrat oder eine Chromschicht umfaßt.

7. Verfahren nach Anspruch 1, gekennzeichnet durch Verwendung des entwickelten Bildes als Maske für eine Bearbeitung des Substrats.

8. Verfahren nach Anspruch 7, gekennzeichnet durch Verwendung des Bildes während eines Ätzprozesses zum Erhalt einer Chrommaske.

9. Verfahren nach Anspruch 7, gekennzeichnet durch Verwendung des Bilds während eines Ätzprozesses oder während eines Metallisierungsprozesses bei der Herstellung einer Vielzahl Halbleiterbauelemente.

**Revendications**

1. Procédé lithographique utile en particulier pour la production de dispositifs à semiconducteurs, comprenant les stades d'exposition d'une matière sensible à des électrons appliquée en revêtement sur un substrat à des électons, pour former une image latente, cette matière sensible à des électrons comprenant un constituant consistant essentiellement en une résine novolaque, et de développement de l'image latente ainsi formée en soumettant la matière exposée à un solvant basique, caractérisé en ce qu'il consiste à employer une composition de la résine novolaque, une dose d'exposition, et un traitement du resist exposé par un fluide gazeux comprenant de l'oxygène, après l'exposition et avant le développement, de manière à favoriser une réaction importante de la résine novolaque sur l'oxygène de sorte que, après développement, quand sensiblement toute l'épaisseur de la région exposée du resist est enlevée, il reste au moins 20% de l'épaisseur d'origine de la région du resist qui n'a pas été exposée.

2. Procédé suivant la revendication 1, caractérisé en ce qu'il consiste à effectuer le traitement du resist qui a été exposé pendant au moins 20 minutes.

3. Procédé suivant la revendication 1, caractérisé en ce qu'il consiste à utiliser comme résine novolaque une résine comprenant le produit de réaction du formaldéhyde et du phénylphénol, ou du n-propylphénol, ou du t-butylphénol.

4. Procédé suivant la revendication 1, caractérisé en ce qu'il consiste à utiliser une résine ayant une masse moléculaire supérieure à 500.

5. Procédé suivant la revendication 1, caractérisé en ce qu'il consiste à éviter dans une grande mesure de cuire la résine après l'exposition.

6. Procédé suivant la revendication 1, caractérisé en ce que le substrat comprend un substrat de silicium ou une couche de chrome.

7. Procédé suivant la revendication 1, caractérisé en ce qu'il consiste à utiliser l'image développée comme masque pour le traitement du substrat.

8. Procédé suivant la revendication 7, caractérisé en ce qu'il consiste à utiliser l'image pendant un processus de gravure pour former un masque au chrome.

9. Procédé suivant la revendication 7, caractérisé en ce qu'il consiste à utiliser l'image pendant un processus de gravure ou pendant un processus de métallisation dans la fabrication de plusieurs dispositifs à semiconducteurs.

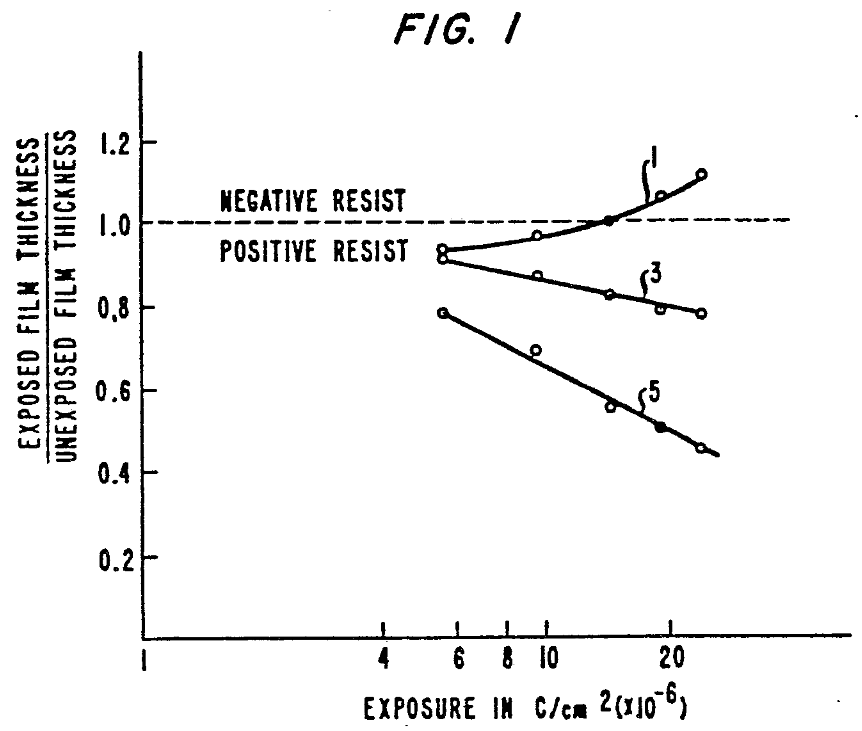
FIG. 1
EXPOSED FILM THICKNESS / UNEXPOSED FILM THICKNESS
1.2
1.0
0.8
0.6
0.4
0.2
NEGATIVE RESIST
POSITIVE RESIST
1
3
5
1
4
6
8
10
20
EXPOSURE IN C/cm 2(x10-6)

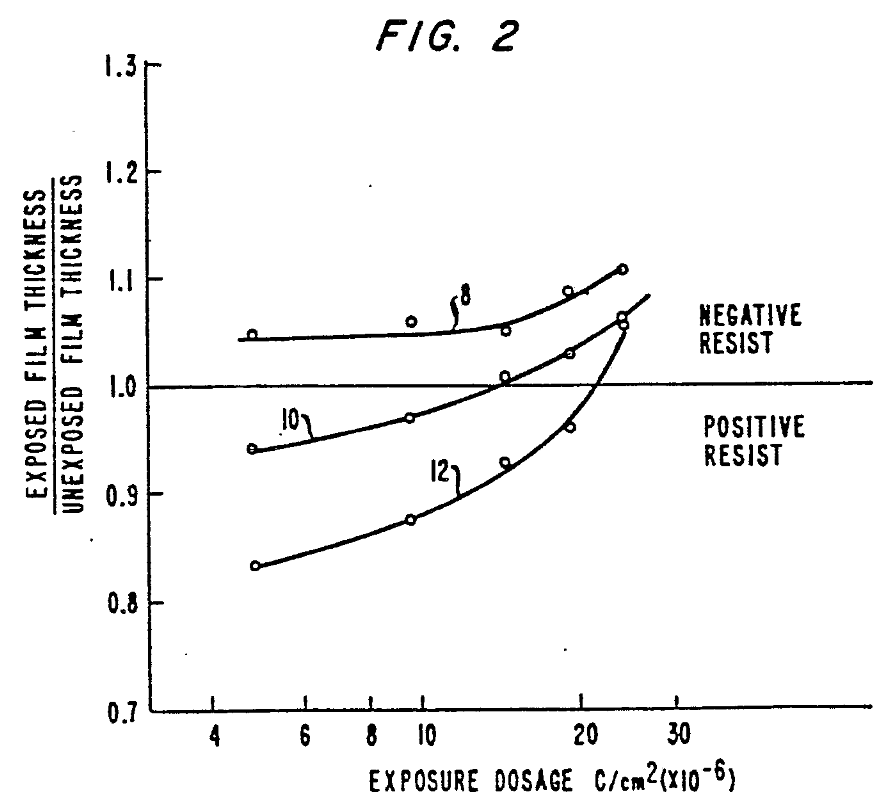
FIG. 2
EXPOSED FILM THICKNESS / UNEXPOSED FILM THICKNESS
1.3
1.2
1.1
1.0
0.9
0.8
0.7
8
10
12
NEGATIVE RESIST
POSITIVE RESIST
4
6
8
10
20
30
EXPOSURE DOSAGE C/cm2(x10-6)